Europäisches Patentamt

European Patent Office

Office européen des brevets

(19)

(11) Veröffentlichungsnummer: **0 274 646 B1**

(12) # EUROPÄISCHE PATENTSCHRIFT

(45) Veröffentlichungstag der Patentschrift: **05.02.92**

(21) Anmeldenummer: **87117830.7**

(22) Anmeldetag: **02.12.87**

(51) Int. Cl.5: **C08G 59/50**, C08J 5/24, H05K 1/03

(54) Verfahren zur Herstellung von Prepregs und deren Verwendung.

(30) Priorität: **15.12.86 DE 3642778**

(43) Veröffentlichungstag der Anmeldung:
**20.07.88 Patentblatt  88/29**

(45) Bekanntmachung des Hinweises auf die Patenterteilung:
**05.02.92 Patentblatt  92/06**

(84) Benannte Vertragsstaaten:
**AT BE CH DE FR GB IT LI NL**

(56) Entgegenhaltungen:
DE-A- 2 743 680
US-A- 2 838 511

(73) Patentinhaber: **Siemens Nixdorf Informations-systeme AG**
**Otto-Hahn-Ring 6**
**W-8000 München 83(DE)**

(72) Erfinder: **Kleeberg, Wolfgang, Dr. Dipl.-Chem.**
**Hessenstrasse 7**
**W-8520 Erlangen(DE)**
Erfinder: **Huber, Jürgen**
**Am Heiligenholz 6**
**W-8520 Erlangen(DE)**
Erfinder: **Hacker, Heinz, Dr. Dipl.-Chem.**
**Kaiserslauterer Strasse 9**
**W-8500 Nürnberg(DE)**
Erfinder: **Wilhelm, Dieter, Dr. Dipl.-Chem.**
**Schubertstrasse 5**
**W-8550 Forchheim(DE)**

(74) Vertreter: **Fuchs, Franz-Josef, Dr.-Ing. et al**
**Postfach 22 13 17**
**W-8000 München 22(DE)**

EP 0 274 646 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Herstellung von Prepregs durch Imprägnieren von Verstärkungsmaterialien aus Glas, Kohlenstoff oder Kunststoff in Form von Fasern, Vliesen oder Geweben oder von Flächenstoffen auf Cellulosebasis mit einer Lösung eines aromatischen und/oder heterocyclischen Polyepoxidharzes und eines aromatischen Polyamins als Härter in einem organischen Lösungsmittel und nachfolgendem Trocknen bei erhöhter Temperatur, sowie aus derartigen Prepregs hergestellte Verbundwerkstoffe.

Verbundwerkstoffe auf der Basis einer vernetzten organischpolymeren Harzmatrix und Verstärkungsmaterialien oder Einlagerungskomponenten in Form von Fasern, Vliesen und Geweben aus Glas, Kohlenstoff oder organisch-synthetischem Material, wie Aramide (d.h. aromatische Polyamide), bzw. von Flächenstoffen auf Cellulosebasis gewinnen in verschiedenen Zweigen der Technik zunehmend an Bedeutung, weil sie in einfacher Weise die Kombination verschiedener besonders vorteilhafter Eigenschaften zu einem fortschrittlichen Gesamteigenschaftsbild gestatten. Entscheidend sind dabei die Eigenschaften des Matrixmaterials. So werden an das Matrixmaterial Anforderungen gestellt, die sowohl eine sichere, reproduzierbare Verarbeitung als auch die weitgehende Nutzung der Eigenschaften der Verstärkungsmaterialien bzw. Einlagerungskomponenten gestatten.

Erste Voraussetzung dafür sind Matrixkomponenten, die die Herstellung lagerfähiger, für die Weiterverarbeitung hinreichend eigenschaftsstabiler Prepregs gestatten. Dazu ist es erforderlich, daß die Prepregs nicht klebend sein dürfen, sie dürfen aber auch nicht vollständig ausgehärtet sein, vielmehr darf die Harzmatrix lediglich vorpolymerisiert sein, d.h. sie muß noch schmelzbar sein. Anforderungen an die vernetzte Harzmatrix bestehen in einer hohen Grenzflächenhaftung zu den Verstärkungsmaterialien und Einlagerungskomponenten und gegebenenfalls auch zu anderen Materialien, beispielsweise metallischen oder keramischen Materialien, welche mit faser- oder gewebeverstärkten Prepregs verbunden werden sollen. Im vernetzten Zustand sind ferner hohe chemische Stabilität, Wärmeformbeständigkeit und - für elektrotechnische Anwendungen - auch dauerhaft hohe elektrische Isolationseigenschaften gefordert.

Derartige Eigenschaften einer vernetzten Polymermatrix können erreicht werden, wenn aromatische und/oder heterocyclische Polyepoxidharze, d.h. Polyglycidylverbindungen, und als Vernetzungskomponente, d.h. als Härter, aromatische Polyamine verwendet werden. Beispiele für derartige Polyamine sind 4.4'-Diaminodiphenylmethan und 4.4'-Diaminodiphenylsulfon (siehe beispielsweise DE-OS 32 10 746) und Polyamine, wie sie aus der DE-PS 27 43 680 bekannt sind. Die letztgenannten Polyamine führen zu besonders wärmeformbeständigen, alterungsstabilen und schwer entflammbaren Netzwerkpolymeren. Es hat sich aber auch gezeigt, daß es sehr schwierig ist, mit Vernetzungskomponenten der vorstehend genannten Art auch die Voraussetzung für eine sichere und reproduzierbare Verarbeitungstechnik zu realisieren.

Aufgabe der Erfindung ist es, das Verfahren der eingangs genannten Art zur Herstellung von Prepregs auf der Basis von Polyepoxidharzen derart auszugestalten, daß die Herstellung lagerstabiler Prepregs ermöglicht wird, wobei andererseits aber gewährleistet sein muß, daß die aus den Prepregs herzustellenden Verbundwerkstoffe die von diesen Werkstoffen geforderten Eigenschaften erfüllen.

Dies wird erfindungsgemäß dadurch erreicht, daß als Härter für das Polyepoxidharz ein 1.3.5-Tris(3-amino-4-alkylphenyl)-2.4.6-trioxo-hexahydrotriazin mit einem $C_1$- bis $C_4$-Alkylrest verwendet wird.

Gegenstand der Erfindung ist somit die Herstellung von Verstärkungsmaterialien bzw. Einlagerungskomponenten enthaltenden Prepregs auf der Basis von Polyepoxidharz, wobei als Härter für das Polyepoxidharz ein Polyamin in Form eines Isocyanursäurederivates der vorstehend genannten Art dient. Gegenstand der Erfindung sind ferner derart hergestellte Prepregs und die Verwendung dieser Prepregs zur Herstellung von Verbundwerkstoffen sowie Verbundwerkstoffe, die wenigstens teilweise aus derartigen Prepregs aufgebaut sind, d.h. Verbundwerkstoffe, die sowohl erfindungsgemäße Prepregs als auch andere Prepregs enthalten. Die Herstellung der Verbundwerkstoffe erfolgt dabei durch Verpressen bei erhöhtem Druck und erhöhter Temperatur.

Die erfindungsgemäßen Prepregs sind kostengünstig herstellbar. Das Polyepoxidharz und der Härter werden dabei in Form von Lösungen auf gängigen Imprägnieranlagen verarbeitet. Dazu können kostengünstige Lösungsmittel, wie Aceton, Ethylacetat, Methylethylketon und Methylglykol (2-Methoxyethanol), verwendet werden. Die imprägnierten Verstärkungsmaterialien bzw. Einlagerungskomponenten werden dann bei erhöhter Temperatur getrocknet, wobei einerseits das Lösungsmittel entfernt wird und andererseits eine Vorpolymerisation des Polyepoxidharzes erfolgt. Insgesamt ergibt sich auf diese Weise ein außerordentlich günstiges Verhältnis von Aufwand zu erzielbaren Eigenschaften.

Nach dem erfindungsgemäßen Verfahren lassen sich Prepregs herstellen, die nicht-klebend und - bei Raumtemperatur - für die Dauer von 6 Wochen und mehr lagerstabil sind, d.h. eine ausreichende Lagerstabilität aufweisen. Darüber hinaus können diese Prepregs zu Verbundwerkstoffen verarbeitet werden, die sich durch eine hohe Glasübergangstemperatur ($T_g$ > 200° C) und durch Schwerentflammbarkeit auszeichnen. Verwendet man als Einlagerungsmaterial beispielsweise Glasgewebe mit einem Masseanteil von 60 bis 62 %, so besitzen die erfindungsgemäßen Verbundwerkstoffe - aufgrund der partiell heterocyclischen Struktur im ausgehärteten Harzsystem - schon ohne den Zusatz kernhalogenierter Komponenten selbstverlöschende Eigenschaften. Messungen an Prüfkörpern gemäß IEC 249-1 ergeben eine mittlere Brenndauer von 5 Sekunden, so daß für die Tauglichkeit nach dieser Norm flammhemmende Zusätze nicht erforderlich sind. Die Verbundwerkstoffe haben weiter den Vorteil, daß sie bei thermischer Überlastung keine korrosiven oder besonders toxischen Spaltprodukte bilden.

Die ausgehärteten Verbundwerkstoffe zeichnen sich ferner durch ein hohes mechanisch-thermisches Eigenschaftsniveau und einen über einen weiten Temperaturbereich konstant kleinen thermischen Ausdehnungskoeffizienten aus. Sie eignen sich deshalb für hochbeanspruchte Konstruktionswerkstoffe, insbesondere aber auch als Materialien zur Herstellung von ein- und zweiseitig kupferkaschierten Leiterplatten, und - bei Verwendung der erfindungsgemäßen Prepregs - zur Herstellung von Multilayer-Schaltungen. Von besonderem Vorteil für die Verwendung als Leiterplattenmaterial ist die hohe Haftfestigkeit von Leiterbahnen aus Kupfer, die hohe Delaminierfestigkeit und eine ausgezeichnete Bearbeitbarkeit, die sich beispielsweise beim Bohren von Durchkontaktierungslöchern darin zeigt, daß einwandfreie Bohrungen bei geringem Bohrerverschleiß erhalten werden. Damit können mit den erfindungsgemäßen Materialien zwei- und mehrlagige Leiterplatten sicherer bzw. kostengünstiger hergestellt werden als mit Materialien, die den derzeitigen Stand der Technik repräsentieren: Bei den gegenwartig in der Leiterplattentechnik in breitem Umfang eingesetzten FR 4-Materialien müssen Bohrungen für die anschließende elektrisch leitende Verbindung der Kupferlagen nachträglich freigeätzt werden; bei Leiterplattenmaterialien auf Polyimidbasis muß, abgesehen vom höheren Materialpreis und einer aufwendigeren Prozeßtechnik bei der Leiterplattenherstellung, mit einem höheren Bohrerverschleiß gerechnet werden.

Die beim erfindungsgemäßen Verfahren als Härter eingesetzten Verbindungen sind aromatische Aminogruppen aufweisende primäre Polyamine. Derartige Polyamine können beispielsweise durch Hydrolyse entsprechender Verbindungen mit freien Isocyanatgruppen hergestellt werden. Ein derartiges Verfahren ist beispielsweise aus der DE-OS 32 27 219 bekannt. Die nach dem bekannten Verfahren hergestellten Polyamine dienen zur Herstellung von Polyurethanen, Polyurethankunststoffen und Polyurethanschaumstoffen. Als eine unter mehreren weiteren Verwendungsmöglichkeiten der Polyamine ist in der DE-OS 32 27 219 zwar "Härter für Epoxid- und Phenolharze" angegeben, es ist aber durchaus überraschend und konnte keineswegs vorhergesehen werden, daß aus der großen Zahl der dort aufgeführten Verbindungen gerade ein spezieller Polyamintyp, nämlich 1.3.5-Tris(3-amino-4-alkylphenyl)-2.4.6-trioxo-hexahydrotriazin, zur Herstellung solcher Prepregs auf der Basis von Polyepoxidharzen eingesetzt werden kann, die lagerstabil sind und bei der Weiterverarbeitung Verbundwerkstoffe mit einem hohen Eigenschaftsniveau ergeben.

Der beim erfindungsgemäßen Verfahren eingesetzte Härter wird aus 2.4-Diisocyanato-alkylbenzolen, wie 2.4-Diisocyanatotoluol, hergestellt. Die Diisocyanato-alkylbenzole (Alkyl = $CH_3$, $C_2H_5$, $C_3H_7$ oder $C_4H_9$) werden dabei mittels geeigneter Katalysatoren trimerisiert und in 1.3.5-Tris(3-isocyanato-4-alkylphenyl)-2.4.6-trioxo-hexahydrotriazine übergeführt. Durch Hydrolyse der Isocyanatgruppen werden daraus dann die Polyamine gebildet.

Wenn in dem bei der Trimerisierung erhaltenen Reaktionsgemisch nicht umgesetztes Ausgangsmaterial, d.h. monomeres Diisocyanato-alkylbenzol, vorhanden ist, werden bei der Hydrolyse als Nebenprodukt aromatische Polyamine gebildet. Derartige Polyamine können beim erfindungsgemäßen Verfahren - neben dem eigentlichen Härter - als additive Härterkomponente eingesetzt werden.

Bei der Hydrolyse des isocyanatgruppenhaltigen Trimerisierungsproduktes kann es auch zu einer Reaktion zwischen Isocyanatgruppen und Aminogruppen kommen. Dabei werden, als Nebenprodukt der Hydrolysereaktion, heterocyclische Polyamine mit Harnstoffgruppierungen erhalten. Derartige Polyamine können beim erfindungsgemäßen Verfahren ebenfalls als additive Härterkomponente eingesetzt werden, d.h. im Gemisch mit dem eigentlichen Härter.

Beim erfindungsgemäßen Verfahren werden als Härter somit bevorzugt Hydrolyseprodukte von trimerisierten Diisocyanato-alkylbenzolen eingesetzt, d.h. Härtergemische. Bei Härtergemischen dieser Art beträgt der Anteil des eigentlichen Härters, d.h. 1.3.5-Tris(3-amino-4-alkylphenyl)-2.4.6-trioxo-hexahydrotriazin, im Gemisch vorteilhaft wenigstens 50 Gew.-%, vorzugsweise zwischen 80 und 95 Gew.-%. Das Verhältnis zwischen eingesetzter Epoxid-Funktion und eingesetzter Aminwasserstoff-Funktion (NH) beträgt beim erfindungsgemäßen Verfahren im übrigen vorteilhaft 0,9:1 bis 1,1:1, vorzugsweise etwa 1:1.

Neben dem eigentlichen Härter bzw. neben Härtergemischen der vorstehend genannten Art können beim erfindungsgemäßen Verfahren auch aromatische Polyamine anderer Art, wie 4.4'-Diaminodiphenylmethan und 4.4'-Diaminodiphenylsulfon, und/oder andere heterocyclische Polyamine eingesetzt werden. Der Anteil derartiger Polyamine im Härtergemisch beträgt maximal 5 Gew.-%.

Geeignete Polyepoxide, d.h. Polyglycidylverbindungen, sind beispielsweise: Epoxidierte Novolake, Polyglycidylether auf Bisphenol A-, Bisphenol F- und Bisphenol B-Basis als solche oder in kernbromierter Form, sowie epoxidierte Hydantoine und Triglycidylisocyanurat; die Epoxide können auch im Gemisch vorliegen. Bevorzugt wird als Polyepoxidharz ein epoxidierter Novolak mit einer Epoxidzahl von 0,3 bis 0,6 und einem Gesamtgehalt an hydrolysierbarem Halogen < 0,6 Gew.-%, vorzugsweise < 0,1 Gew.-%, verwendet. Vorteilhaft kann der epoxidierte Novolak zusammen mit Triglycidylisocyanurat oder zusammen mit einem kernhalogenierten Bisphenol-bisglycidylether bzw. einem kernhalogenierten epoxidierten Novolak verwendet werden, wobei der Gesamtgehalt des Gemisches an kerngebundenem Halogen ≤ 4 Gew.-% ist.

Als Einlagerungskomponenten dienen, wie bereits ausgeführt, Flächenstoffe auf Cellulosebasis oder Verstärkungsmaterialien aus Glas, aus Kohlenstoff oder aus Kunststoff, d.h. aus organisch-synthetischem Material, wie hochwärmebeständige Hochmodulfasern, beispielsweise auf Aramid- oder Polyphenylensulfid-Basis, in Form von Geweben oder Vliesen. Bei Verwendung von Verstärkungsmaterialien der genannten Art werden Prepregs für mechanisch hoch beanspruchbare Konstruktionswerkstoffe erhalten. Diese Konstruktionswerkstoffe eignen sich beispielsweise für Anwendungen im Maschinenbau, im Fahrzeugbau, in der Flugtechnik und in der Elektrotechnik, insbesondere in Form von Prepregs für die Leiterplattentechnik.

Anhand von Ausführungsbeispielen soll die Erfindung noch näher erläutert werden.

Beispiel 1

Herstellung von 1.3.5-Tris(3-isocyanato-4-methylphenyl)-2.4.6-trioxo-hexahydrotriazin

500 g 2.4-Diisocyanatotoluol (NCO-Gehalt: 48,2 %) werden mit Natriumbenzoat, gelöst in Dimethylformamid, trimerisiert (siehe dazu US-PS 2 801 244). Nach etwa 1 h wird die Reaktion bei einem NCO-Wert von 24,8 % durch Zugabe von p-Toluolsulfonsäure gestoppt.

Beispiel 2

Herstellung von 1.3.5-Tris(3-amino-4-methylphenyl)-2.4-6-trioxo-hexahydrotriazin

Die Hydrolyse von Isocyanatverbindungen zu den entsprechenden Aminen ist in der Literatur hinreichend beschrieben. Beispiele für die Hydrolyse mit Hilfe von basischen und sauren Katalysatoren finden sich in FR-PS 14 15 317, DE-AS 11 55 907, DE-OS 29 48 419, DE-OS 30 39 600, DE-OS 31 12 118, DE-OS 32 44 912 und DE-OS 32 44 913. Eine andere Möglichkeit der Aminsynthese beruht auf der thermischen Spaltung von Additionsprodukten aus Isocyanaten und Alkohol, wie sie beispielsweise in DE-AS 12 70 046 und DE-OS 30 35 639 beschrieben ist. Die Hydrolyse von Isocyanatverbindungen verläuft besonders vorteilhaft mit konzentrierter Schwefelsäure (entsprechend DE-PS 27 43 680) oder in hochsiedenden Lösungsmitteln (entsprechend DE-OS 32 27 219).

Bei der Hydrolyse von 1.3.5-Tris(3-isocyanato-4-methylphenyl)-2.4.6-trioxo-hexahydrotriazin entsprechend DE-OS 32 27 219 wird einer heißen Mischung aus Dimethylacetamid, Wasser und Florisil als Katalysator (Florisil®, ein Produkt der Fa. Floridin Corp., besteht im wesentlichen aus Magnesiumsilicat) eine Lösung des nach Beispiel 1 hergestellten Trimerisats in Dimethylacetamid zugesetzt. Nach der Aufarbeitung wird ein Gemisch aus 1.3.5-Tris(3-amino-4-methylphenyl)-2.4.6-trioxo-hexahydrotriazin und heterocyclischen Polyaminen mit einem $NH_2$-Gehalt von 7,9 Gew.-% erhalten.

Beispiel 3

Herstellung von Prepregs

3000 Gewichtsteile eines epoxidierten Novolaks mit einem Epoxidwert von 0,57 werden in 1600 Gewichtsteilen einer 1:1-Mischung von Aceton und Methylglykol gelöst. Zu dieser Lösung wird eine Lösung von 1730 Gewichtsteilen des nach Beispiel 2 hergestellten Härtergemisches ($NH_2$-Gehalt: 7,9 Gew.-%) in 1000 Gewichtsteilen einer 1:1-Mischung von Aceton und Methylglykol gegeben. Mit der dabei erhaltenen 65 %igen Lösung wird ein Glasgewebe (Leinwandbindung, Flächengewicht: 197 g/m²) imprägniert. Nach dem Imprägnieren wird das Lösungsmittel in einer Trockenanlage von 10 m Länge bei Temperaturen von 80 bis 150˚C entfernt (Abziehgeschwindigkeit: 2 m/min). Derart hergestellte Prepregs sind nicht-klebend und bei Raumtemperatur mehr als 6 Wochen lagerstabil.

Beispiel 4

Herstellung von Verbundwerkstoffen

Aus den entsprechend Beispiel 3 hergestellten Prepregs werden Verbundwerkstoffe in Form von zwei- und mehrlagigen Leiterplatten hergestellt. Die Verarbeitung erfolgt in Etagenpressen bei einer Temperatur von 170°C und einem Druck von 70 bar. Die Untersuchung des dabei erhaltenen Leiterplattenmaterials bezüglich der elektrischen und mechanisch-thermischen Eigenschaften sowie hinsichtlich der Bearbeitbarkeit ergeben ausgezeichnete Resultate.

Im einzelnen sind dies:
- Glasübergangstemperatur $T_g$:
ohne Tempern : 203°C
2 h bei 190°C getempert: 225°C
2 h hei 210°C getempert: 243°C;
- Haftvermögen einer 18 $\mu$m-Kupferfolie bei Raumtemp.: 1,4 N/mm;
- Lagenbindung: beim Kugeltest keine Delaminierung;
- Lötbadtest: bestanden, 270°C/20 s;
- Oberflächenwiderstand: $1,2 \times 10^{14}$ $\Omega$ ;
- tan$\delta$ (Raumtemperatur, 50 Hz): $10 \times 10^{-3}$;
- $\epsilon_r$ (Raumtemperatur, 50 Hz): 5,15;
- mittlere Brenndauer nach IEC 249-1: 5 s;
- Schneidbarkeit mit Prüfschnitt nach DIN 53 488: bestanden;
- Bohrbarkeit: nach 2204 Hüben im 1er Stapel kein außergewöhnlicher Verschleiß der Bohrerschneiden; kein Freiätzen der Bohrungen erforderlich.

Erfindungsgemäße Verbundwerkstoffe für Leiterplatten sind somit insgesamt rationeller verarbeitbar als Materialien der Güteklasse FR 4, die zudem weniger wärmeformbeständig sind. Die Glasübergangstemperatur der erfindungsgemäßen Verbundwerkstoffe ($T_g$: 220 bis 250°C) erreicht fast das Niveau von Polyimidmaterialien ($T_g$: 250 bis 260°C), die aber in der Herstellung, der Verarbeitung, der Bearbeitbarkeit und nicht zuletzt in den Materialkosten wesentlich aufwendiger sind. Das Haftvermögen einer 18 $\mu$m-Kupferfolie (bei Raumtemperatur) beträgt - im Vergleich zum Wert von 1,4 N/mm bei den erfindungsgemäßen Verbundwerkstoffen - 1,2 bis 1,4 N/mm bei FR 4-Material und 1,0 bis 1,2 N/mm bei Polyimidmaterial. Neben den verbesserten thermomechanischen Eigenschaften und einer inhärenten Schwerentflammbarkeit zeichnen sich die erfindungsgemäßen Verbundwerkstoffe im Vergleich zu FR 4-Materialien (mit einem Gehalt von 17 bis 18 Gew.-% Brom) weiterhin dadurch aus, daß sie mit einem Halogenzusatz von maximal bis zu 4 % das gleiche Brennverhalten wie FR 4-Materialien erreichen und damit im Falle der thermischen Überlastung durch Abspaltung gasförmiger Spaltprodukte zu deutlich reduzierten Sekundärschäden führen.

## Patentansprüche

1. Verfahren zur Herstellung von Prepregs durch Imprägnieren von Verstärkungsmaterialien aus Glas, Kohlenstoff oder Kunststoff in Form von Fasern, Vliesen oder Geweben oder von Flächenstoffen auf Cellulosebasis mit einer Lösung eines aromatischen und/oder heterocyclischen Polyepoxidharzes und eines aromatischen Polyamins als Härter in einem organischen Lösungsmittel und nachfolgendem Trocknen bei erhöhter Temperatur, **dadurch gekennzeichnet,** daß als Härter ein 1.3.5-Tris-(3-amino-4-alkylphenyl)-2.4.6-trioxo-hexahydrotriazin mit einem $C_1$- bis $C_4$-Alkylrest verwendet wird.

2. Verfahren nach Anspruch 1, **dadurch gekennzeichnet,** daß das 1.3.5-Tris(3-amino-4-alkylphenyl)-2.4.6-trioxo-hexahydrotriazin im Gemisch mit weiteren aromatischen und/oder heterocyclischen Polyaminen verwendet wird.

3. Verfahren nach Anspruch 2, **dadurch gekennzeichnet,** daß der Anteil an 1.3.5-Tris(3-amino-4-alkylphenyl)-2.4-6-trioxo-hexahydrotriazin im Härtergemisch wenigstens 50 Gew.-% beträgt.

4. Verfahren nach einem der Ansprüche 1 bis 3, **dadurch gekennzeichnet,** daß das Verhältnis zwischen Epoxid- und Aminwasserstoff-Funktion 0,9:1 bis 1,1:1 beträgt.

5. Verfahren nach einem oder mehreren der Ansprüche 1 bis 4, **dadurch gekennzeichnet,** daß als Polyepoxidharz ein epoxidierter Novolak mit einer Epoxidzahl von 0,3 bis 0,6 und einem Gesamtgehalt an hydrolysierbarem Halogen < 0,6 Gew.-% verwendet wird.

6. Verfahren nach Anspruch 5, **dadurch gekennzeichnet,** daß der epoxidierte Novolak zusammen mit Triglycidylisocyanurat verwendet wird.

7. Verfahren nach Anspruch 5, **dadurch gekennzeichnet,** daß der epoxidierte Novolak zusammen mit einem kernhalogenierten Bisphenolbisglycidylether und/oder einem kernhalogenierten epoxidierten Novolak verwendet wird, wobei der Gesamtgehalt an kerngebundenem Halogen $\leq$ 4 Gew.-% beträgt.

8. Prepregs, hergestellt nach dem Verfahren nach einem oder mehreren der Ansprüche 1 bis 7.

9. Verwendung der Prepregs nach Anspruch 8 zur Herstellung von Verbundwerkstoffen, insbesondere zur Herstellung von zwei- und mehrlagigen Leiterplatten für die Elektrotechnik.

10. Verbundwerkstoffe, **dadurch gekennzeichnet,** daß sie wenigstens teilweise aus Prepregs nach Anspruch 8 hergestellt sind.

**Claims**

1. Process for the production of prepregs by impregnating reinforcement materials of glass, carbon or plastic in the form of fibres, nonwoven or woven materials or cellulose-based 2-dimensional materials, with a solution of an aromatic and/or heterocyclic poly epoxy resin and an aromatic polyamine as hardener in an organic solvent, and subesequent drying at elevated temperature, characterised in that a 1,3,5-tris(3-amino-4-alkylphenyl)-2,4,6-trioxo-hexahydrotriazine with a $C_1$- to $C_4$- alkyl radical is used as the hardener.

2. Process according to claim 1, characterised in that the 1,3,5-tris(3-amino-4-alkylphenyl)-2,4,6-trioxo-hexahydrotriazine is used in a mixture with other aromatic and/or heterocyclic polyamines.

3. Process according to claim 2, characterised in that the content of 1,3,5-tris(3-amino-4-alkylphenyl)-2,4,6-trioxo-hexahydrotriazine in the hardener mixture is at least 50% by weight.

4. Process according to one of claims 1 to 3, characterised in that the ratio between epoxy- and amine hydrogen-functions is 0.9:1 to 1.1:1.

5. Process according to one or more than one of claims 1 to 4, characterised in that an epoxidised novolak with an epoxy number of from 0.3 to 0.6 and a total content of hydrolysable halogen of < 0.6% by weight is used as the poly epoxy resin.

6. Process according to claim 5, characterised in that the epoxidised novolak is used together with triglycidylisocyanurate.

7. Process according to claim 5, characterised in that the epoxidised novolak is used together with a nucleushalogenated bisphenol-bisglycidyl ether and/or a nucleus halogenated epoxidised novolak, the total content of nucleus-bound halogen being ≦ 4% by weight.

8. Prepregs produced according to the process of one or more than one of claims 1 to 7.

9. Use of the prepregs according to claim 8 for the production of composite materials, in particular for the production of double- and multi-layered circuit boards for electrical engineering.

10. Composite materials, characterised in that they are produced at least partially from prepregs according to claim 8.

**Revendications**

1. Procédé de préparation de préimprégnés par imprégnation de matériaux de renforcement en verre, en carbone ou en matière plastique sous forme de fibres, de nontissés ou de tissus ou de matières planes à base de cellulose, par une solution d'une résine de polyépoxyde aromatique et/ou hétérocyclique et d'une polyamine aromatique comme durcisseur dans un solvant organique suivi d'un séchage à température élevée, caractérisé en ce qu'il consiste à utiliser comme durcisseur une 1,3,5-tris(3-amino-4-alcoylphényl)-2,4,6-trioxo-hexahydrotriazine ayant un radical alcoyle de 1 à 4 atomes de carbone.

2. Procédé suivant la revendication 1, caractérisé en ce qu'il consiste à utiliser la 1,3,5-tris(3-amino-4-alcoylphényl)-2,4-6-trioxo-hexahydrotriazine en mélange avec d'autres polyamines aromatiques et/ou hétérocycliques.

3. Procédé suivant la revendication 2, caractérisé en ce que la proportion de 1,3,5-tris(3-amino-4-alcoylphényl)-2,4-6-trioxo-hexahydrotriazine représente au moins 50 % du poids du mélange des durcisseurs.

4. Procédé suivant l'une des revendications 1 à 3, caractérisé en ce que le rapport entre la fonction époxyde et la fonction NH est compris entre 0,9:1 et 1,1:1.

5. Procédé suivant l'une ou plusieurs des revendications 1 à 4, caractérisé en ce qu'il consiste à utiliser comme résine polyépoxyde une résine novolaque époxydée ayant un indice d'époxyde de 0,3 à 0,6 et une teneur totale en halogène hydrolysable < 0,6 % en poids.

6. Procédé suivant la revendication 5, caractérisé en ce qu'il consiste à utiliser la résine novolaque époxydée en même temps que de l'isocyanurate de triglycidyle.

7. Procédé suivant la revendication 5, caractérisé en ce qu'il consiste à utiliser la résine novolaque époxydée en même temps qu'un oxyde bisglycidylique du bisphénol halogéné sur le cycle et/ou une résine novolaque époxydée halogénée sur le cycle, la teneur totale en halogène reliée au cycle étant ≦ 4 % en poids.

8. Préimprégnés préparés par le procédé suivant l'une ou plusieurs des revendications 1 à 7.

9. Utilisation des préimprégnés suivant la revendication 8 pour fabriquer des matériaux composites, notamment pour la préparation de plaquettes de circuits imprimés à deux couches ou à plusieurs couches pour l'électrotechnique.

10. Matériaux composites, caractérisés en ce qu'ils sont fabriqués au moins en partie à partir de préimprégnés suivant la revendication 8.